# EUROPEAN PATENT SPECIFICATION

(11) **EP 3 620 786 B1**
(45) Date of publication and mention of the grant of the patent: **16.11.2022**
(21) Application number: 19195294.4
(22) Date of filing: 04.09.2019
(51) Int. Cl.: G01N 27/70, G01R 19/00, H01T 23/00, H05F 3/06, G01R 29/24

(54) **ION SENSOR**
IONENSENSOR
CAPTEUR D'IONS

(30) Priority: 10.09.2018 US 201816126157
(43) Date of publication of application: 11.03.2020
(73) Proprietor: NRD LLC, Grand Island, NY 14072 (US)
(72) Inventor: MARONI, Timothy, Grand Island, NY 14072 (US); WILLDEN, Jeremy Paul, Pleasant Grove, UT 84062 (US); JOHNSON, Martin Robert, Draper, UT 84020 (US); FERGUSON, Helaman David Pratt, Orem, UT 84097 (US); FILOSO, John Patrick, Pleasant Grove, UT 84062 (US); JENSEN, Jonathan Scott, Pocatello, ID 83201 (US); HABINSHUTI, Victor, Williamsville, NY 14221 (US); BRIM, Derek, Buffalo, NY 14211 (US); DODGE, Spencer Ralph, Sammamish, WA 98075 (US); GOOCH, Robert Edmund, Orem, UT 84058 (US); BURRIDGE, Gary, Grand Island, NY 14072 (US); GLYNN, John M., Burlington, MA 01803 (US)
(74) Representative: Reichert & Lindner Partnerschaft Patentanwälte

(56) References cited:
- WO-A2-2006/050086
- JP-A- 2011 124 006
- US-A- 4 121 105

## Description

### FIELD

The present disclosure relates to an ionizer system, and, more particularly, to an ionizer system having a controller that monitors and regulates the ions in the air using a sensor and at least one ionizer.

### BACKGROUND

Air ionizers are often used in places where work is done involving static-electricity-sensitive electronic components, to eliminate the build-up of static charges on non-conductors as well as static cling. As those elements are very sensitive to electricity, they cannot be grounded because the rapid discharge will destroy them as well. Usually, the work is done over a special dissipative table mat, which allows a very slow discharge, and under the air gush of an ionizer. For example, clean rooms having expensive and sensitive machines therein often require ionizers to neutralize static charge therein. In another example, ionizers may be used in environments containing explosive gases or powders.

Historically, effectiveness of anti-static ionizers has been verified by the use of a charged plate monitor (CPM). The monitor consists of a metal plate exposed to the air, which is charged to a substantial voltage (typically on the order of+1000V or -1000V). A non-contact, or other very high impedance, voltmeter measures the voltage on the plate as it discharges. The ions of opposite charge in the air are attracted to the charged plate, and when they come in contact with the plate, the charge is neutralized. The discharge time of the plate is used as a measurement of the effectiveness of the ionization system. Some of the disadvantages of this system include: lack of continuous monitoring; potential safety hazards of the exposed high-voltage plate; the depletion of the ions near the charged plate, thereby reducing the effectiveness of the ionization protection when a test is in process; and, relatively large plate area. Additionally, CPMs typically can only sense positive ions or negative ions, not both, at a time. Or, two separate CPMs would be utilized, one detecting positive ions and the other detecting negative ions, each requiring its own power source.

WO 2006/050086 A2, US 4,121,105 A and JP 2011 124006 A disclose several examples of ion sensors.

Thus, there has been a long-felt need for a sensor that overcomes the limitations of traditional CPMs by performing continuous measurement of the ion current, rather than making an indirect measurement on the voltage of a plate as it discharges due to the ion current. Additionally, there has been a long-felt need for an ionization monitoring system that communicates with the sensor and one or more ionizers, to automatically adjust ion production to maintain ion balance in the air.

### SUMMARY

According to aspects illustrated herein, there is provided a sensor for sensing ions, comprising a circuit board assembly, and a core assembly connected to the circuit board assembly, the core including a first electrical conductor and a second electrical conductor.

According to aspects illustrated herein, there is provided a sensor for sensing ions, comprising a circuit board assembly, a core assembly connected to the circuit board assembly, the core including a first rod, a second rod, a first plate connected to the first rod, and a second plate connected to the second rod, and a cage at least partially surrounding the core assembly and electrically connected to the circuit board assembly.

According to an example not forming part of the present invention, there is provided a sensor for sensing ions, comprising a circuit board assembly, a core, a cage at least partially surrounding the core, a first wire wrapped around the core and connected to the circuit board assembly, a second wire wrapped around the core and connected to the circuit board assembly, and a third wire connecting the cage to the circuit board assembly.

According to an example not forming part of the present invention, there is provided an ionizer system, comprising a controller, at least one sensor connected to the controller, the at least one sensor including a first circuit board assembly, a core, a cage at least partially surrounding the core, a first wire wrapped around the core and connected to the first circuit board assembly, a second wire wrapped around the core and connected to the first circuit board assembly, and a third wire connecting the cage to the first circuit board assembly, and at least one ionizer connected to the controller.

According to an example not forming part of the present invention, there is provided a method of monitoring an ionizing system, the method comprising receiving a first set of data from at least one sensor of an unacceptable rate/quantity of ions, making a first determination, based on the first set of data, whether more ions or fewer ions are needed, sending a first signal, based on the first determination, to at least one ionizer to produce more ions or fewer ions, sending a first communication about the first determination and the first signal to a remote computing device, receiving a second set of data from the at least one sensor of an acceptable rate/quantity of ions, making a second determination, based on the second set of data, that no more ions or fewer ions are needed, sending a second signal, based on the second determination, to the at least one ionizer to produce the same rate of ions, sending a second communication about the second determination and the second signal to the remote computing device, receiving a third set of data from the at least one sensor of an ion imbalance, making a third determination, based on the third set of data, whether positive ions or negative ions are needed, sending a third signal, based on the third determination, to at least one ionizer to produce the positive ions or negative ions, sending a third communication about the third determination and the third signal to a remote computing device, receiving a fourth set of data from the at least one sensor of an ion balance, making a fourth determination, based on the fourth set of data, that no positive ions or negative ions are needed, sending a fourth signal, based on the fourth determination, to the at least one ionizer to stop producing positive and negative ions, and sending a fourth communication about the fourth determination and the fourth signal to the remote computing device.

According to an example not forming part of the present invention, there is provided a method of monitoring an ionizing system, the method comprising receiving a first set of data from at least one sensor of an ion imbalance, making a first determination, based on the first set of data, whether positive ions or negative ions are needed, sending a first signal, based on the first determination, to at least one ionizer to produce the positive ions or negative ions, sending a first communication about the first determination and the first signal to a remote computing device, receiving a second set of data from the at least one sensor of an ion balance, making a second determination, based on the second set of data, that no positive ions or negative ions are needed, sending a second signal, based on the second determination, to the at least one ionizer to stop producing positive and negative ions, and sending a second communication about the second determination and the second signal to the remote computing device.

According to an example not forming part of the present invention, there is provided a method of monitoring an ionizing system, the method comprising receiving a first set of data from at least one sensor of an unacceptable rate/quantity of ions, making a first determination, based on the first set of data, whether more ions or fewer ions are needed, sending a first signal, based on the first determination, to at least one ionizer to produce more ions or fewer ions, sending a first communication about the first determination and the first signal to a remote computing device, receiving a second set of data from the at least one sensor of an acceptable rate/quantity of ions, making a second determination, based on the second set of data, that no more ions or fewer ions are needed, sending a second signal, based on the second determination, to the at least one ionizer to produce the same rate of ions, and sending a second communication about the second determination and the second signal to the remote computing device.

The sensor of the invention overcomes the limitations of traditional CPMs by performing continuous measurement of the ion current, rather than making an indirect measurement on the voltage of a plate as it discharges due to the ion current. The measurement of current is enabled by a very low-leakage, high-impedance amplifier, configured as a "transimpedance amplifier." This configuration converts current to voltage and is often used to detect small currents in photodiodes, such as those detecting optical data at the end of a long fiber-optic cable. This configuration enables measurements on the order of picoamps, an extremely low current level. For comparison, one Amp of current is equivalent to 6.25 × 10¹⁸ electrons per second, similar to the amount of current required to charge a cell phone. One picoamp is only 6,250,000 electrons per second, and a measurement of one picoamp of current represents approximately 6 million ions colliding with the sensor element per second.

In some examples not forming part of the present invention, the sensor itself is composed of two interleaved wire helices wrapped around a common core element, surrounded by a metal (conductive) shield with openings to allow airflow. The shield protects the sensor helices from electric fields which would otherwise affect the measurements and thus the readings. The conductive metal shield is connected to the electrical ground plane of the sensor circuit boards. The circuit boards are also enclosed with conductive metal shielding to prevent interference, essentially forming a Faraday cage around the sensitive circuitry. In some examples not forming part of the present invention, the common core element comprises parallel stripes along the length thereof with adjacent stripes having alternating polarity. In some examples not forming part of the present invention, the common core element comprises a plurality of straight parallel wires. In some examples not forming part of the present invention, the common core element comprises a plurality of helically arranged wires.

The two helices are charged to voltages of approximately +35V and -35V, respectively, though the precise voltage may be adjusted for various reasons, including adjusting sensitivity, calibration, or to accommodate specific requirements of the customer. The helix with a positive charge, when impacted by negative ions, gains electrons, and the transimpedance amplifier converts this ion current into a voltage. Similarly, the negatively charged helix, when impacted by positive ions, loses electrons, and the transimpedance amplifier converts this current to a voltage as well. These voltages are filtered, amplified, conditioned, and ultimately digitized by an Analog to Digital Converter (ADC). The resulting digitized values are processed through proprietary algorithms to produce a result equivalent to the discharge time measured by a CPM. The measurements are also processed through a different proprietary algorithm to determine the Direct Current (DC) balance of the ionizing system. If an uncharged CPM is placed in an ionizing stream, ideally, the plate would remain at zero volts with respect to ground, but many ionizers produce a slight imbalance in their ion streams, resulting in the CPM receiving a small positive or negative charge. The sensor of the instant invention can also measure this DC offset, essentially by comparing the results of the positive and negative helix currents.

The digitized data sets are converted to a serial message format and transmitted via RS-485 (or another communication physical layer) to a controller. The level of ionization and the DC balance will be used to send control messages from the controller to an ionizer, adjusting it to ensure optimal protection against electrical charge buildup. The controller stores some data short-term and feeds the information via a network protocol (e.g., via Wi-Fi, Ethernet, or any other suitable method) to a data aggregator, which handles long-term storage of the measurements (e.g., computing device). A user interface, initially a web browser in a computer, tablet, or mobile device, provides measurements, graphs, and alerts to the user. Cloud connectivity is also an option, enabling enterprise-wide monitoring. Connectivity to other process automation software and hardware will allow improved process control and product manufacturing monitoring, enabling traceability of a particular item back to each manufacturing step, and a log of how effective the anti-static measures were.

The controller provides for automatic, real-time adjustment of ionizer DC balance, data logging of measured ionizer performance, and a remote, distributed system allowing for a Wi-Fi/Wireless/Wired network, local control, central data aggregation, cloud connectivity, user notification/email/paging/display, Web Interface, and mobile app access and control. The controller further provides an extensible system to allow addition of new sensors, indicators, ionizers, and other components in the future.

The present disclosure includes a sensor for sensing ions according to independent claim 1, comprising a circuit board assembly, and a core assembly connected to the circuit board assembly, the core including a first electrical conductor and a second electrical conductor. The sensor may further comprise a housing at least partially enclosing the circuit board assembly, the housing including a first end and a second end. The sensor may further comprise a port connected to the circuit board assembly, the port arranged proximate the first end. The sensor may further comprise a cage at least partially surrounding the core assembly and electrically connected to the circuit board assembly.

According to the invention, the circuit board assembly comprises a first circuit board connected to the first electrical conductor, and a second circuit board connected to the second electrical conductor. The circuit board assembly may further comprise a third circuit board.

In some embodiments, the cage is electrically connected to a ground plane of at least one of the first circuit board and the second circuit board. According to the invention, the core assembly further comprises at least one plate connected to the first electrical conductor and/or the second electrical conductor. According to the invention, the at least one plate comprises at least a first plate connected to the first electrical conductor and a second plate connected to the second electrical conductor.

According to the invention, the first electrical conductor is charged with a positive voltage and operatively arranged to collect negative ions, and the second electrical conductor is charged with a negative voltage and operatively arranged to collect positive ions.

In some embodiments, the first and second electrical conductors are rods. In some embodiments, the first and second electrical conductors are wires.

These and other objects, features, and advantages of the present disclosure will become readily apparent upon a review of the following detailed description of the disclosure, in view of the drawings and appended claims.

### BRIEF DESCRIPTION OF THE DRAWINGS

Various embodiments are disclosed, by way of example only, with reference to the accompanying schematic drawings in which corresponding reference symbols indicate corresponding parts, in which:
Figure 1 is a front perspective view of an ionizer system;
Figure 2 is a top perspective view of a sensor, not forming part of the present invention, as shown in Figure 1;
Figure 3 is an exploded perspective view of the sensor, not forming part of the present invention, shown in Figure 2;
Figure 4 is a perspective view of a circuit board assembly as shown in Figure 3;
Figure 5 is a perspective view of a controller, as shown in Figure 1;
Figure 6 is a top elevational view of the controller shown in Figure 5;
Figure 7 is a front elevational view of the controller shown in Figure 5;
Figure 8 is a rear elevational view of the controller shown in Figure 5;
Figure 9 is a schematic view of a controller;
Figure 10 is a flow chart of a method of controlling the ionizer system of Figure 1;
Figure 11 is an elevational view of a sensor according to the present invention;
Figure 12 is a cross-sectional view of the sensor, taken generally along line **12-12** in Figure 11;
Figure 13 is an exploded perspective view of the sensor shown in Figure 11;
Figure 14A is a perspective view of a core assembly, as shown in Figure 13;
Figure 14B is a side elevational view of the core assembly shown in Figure 14A; and,
Figure 14C is a front elevational view of the core assembly shown in Figure 14A.

### DETAILED DESCRIPTION

At the outset, it should be appreciated that like drawing numbers on different drawing views identify identical, or functionally similar, structural elements. It is to be understood that the claims are not limited to the disclosed aspects.

Furthermore, it is understood that this disclosure is not limited to the particular methodology, materials and modifications described and as such may, of course, vary. It is also understood that the terminology used herein is for the purpose of describing particular aspects only, and is not intended to limit the scope of the claims.

Unless defined otherwise, all technical and scientific terms used herein have the same meaning as commonly understood to one of ordinary skill in the art to which this disclosure pertains. It should be understood that any methods, devices or materials similar or equivalent to those described herein can be used in the practice or testing of the example embodiments.

It should be appreciated that the term "substantially" is synonymous with terms such as "nearly," "very nearly," "about," "approximately," "around," "bordering on," "close to," "essentially," "in the neighborhood of," "in the vicinity of," etc., and such terms may be used interchangeably as appearing in the specification and claims. It should be appreciated that the term "proximate" is synonymous with terms such as "nearby," "close," "adjacent," "neighboring," "immediate," "adjoining," etc., and such terms may be used interchangeably as appearing in the specification and claims. The term "approximately" is intended to mean values within ten percent of the specified value.

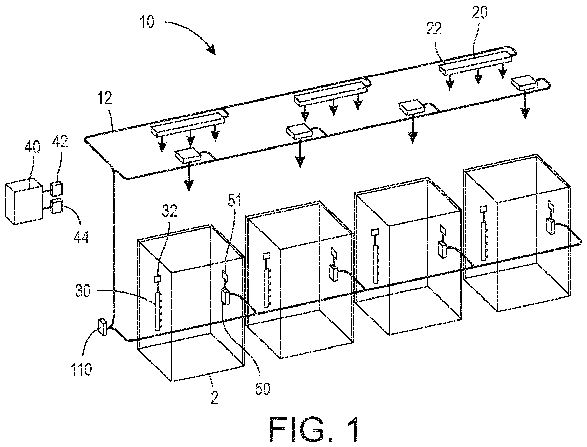

Adverting now to the figures, Figure 1 is a front perspective view of ionizer system **10**. Ionizer system generally comprises sensor **50**, controller **110**, and at least one ionizer. In some embodiments, ionizer system comprises whole room ionizer **20**, individual ionizer **30**, sensor **50**, and controller **110**. Whole room ionizer **20**, individual ionizer **30**, and sensor **50** are connected to controller **110** via electrical conduit **12**. whole room ionizer **20**, individual ionizer **30**, and sensor **50** are also provided power through electrical conduit **12**. However, it should be appreciated that whole room ionizer **20**, individual ionizer **30**, and sensor **50** may be connected to controller **110** via wireless communication, for example, Wi-Fi, Bluetooth technology, ZigBee, Infrared (IR), Radio, or any other suitable wireless communication method. In a wireless embodiment, whole room ionizer **20**, individual ionizer **30**, and sensor **50** would each have a suitable power source, for example, AC mains or battery. Controller **110** is capable of wirelessly communicating with remote computing device **40**. Computing device **40** includes receiver **42** for receiving information from controller **110** and transmitter **44** for sending information to controller **110**. Computing device **40** may also have a digital user interface.

Whole room ionizer **20** is a device that uses high voltage to ionize (electrically charge) air molecules. Whole room ionizer **20** is capable of generating negative ions, or anions, which are particles with one or more extra electron, conferring a net negative charge to the particle. Whole room ionizer **20** is also capable of generating positive ions, or cations, which are ions missing one or more electrons, resulting in a net positive charge. Whole room ionizer **20** may comprise a fan physically built therein. As ions are generated, the fan distributes the ions throughout the room or space. Whole room ionizer **20** is connected to controller **110** via electrical conduit **12**. Whole room ionizer **20** is generally in communication with sensor **50**. Specifically, whole room ionizer **20** receives instructions from controller **110** to distribute more negative ions and/or positive ions throughout the space or room. In some embodiments, whole room ionizer **20** comprises receiver **22** and receives instructions from controller **110** via wireless transmission, without the need for physical electrical connection therebetween. It should be appreciated that ionizer system **10** may have any number of whole room ionizers to provide suitable ionization for the environment. For example, ionizer system **10** may have one or more whole room ionizers arranged thereon.

Individual ionizer **30** is a device that uses high voltage to ionize (electrically charge) air molecules. Individual ionizer **30** is capable of generating negative ions, or anions, which are particles with one or more extra electron, conferring a net negative charge to the particle. Individual ionizer **30** is also capable of generating positive ions, or cations, which are ions missing one or more electrons, resulting in a net positive charge. Individual ionizer **30** is preferably arranged on, or close in proximity to, machine **2**. Individual ionizer **30** provides a higher concentration of ions directly around machine **2**, whereas whole room ionizer **20** distributes ions generally to the entire space or room. Individual ionizer **30** may use compressed air to distribute ions, rather than a fan as in whole room ionizer **20**. For example, as ions are generated, the compressed air distributes the ions directly around machine **2**. In some embodiments, individual ionizer **30** is connected to a compressor, which provides the compressed air. It should be appreciated that individual ionizer **30** may use a fan to distribute ions, and that whole room ionizer **20** may use compressed air to distribute ions. Individual ionizer **30** is connected to controller **110** via electrical conduit **12**. Individual ionizer **30** is generally in communication with sensor **50**. Specifically, individual ionizer **30** receives instructions from controller **110** to distribute more negative ions and/or positive ions throughout to and around machine **2**. In some embodiments, individual ionizer **30** comprises receiver **32** and receives instructions from controller **110** via wireless transmission, without the need for physical electrical connection therebetween. It should be appreciated that ionizer system **10** may have any number of individual ionizers to provide suitable ionization for the environment. For example, every machine may have one or more individual ionizers arranged thereon.

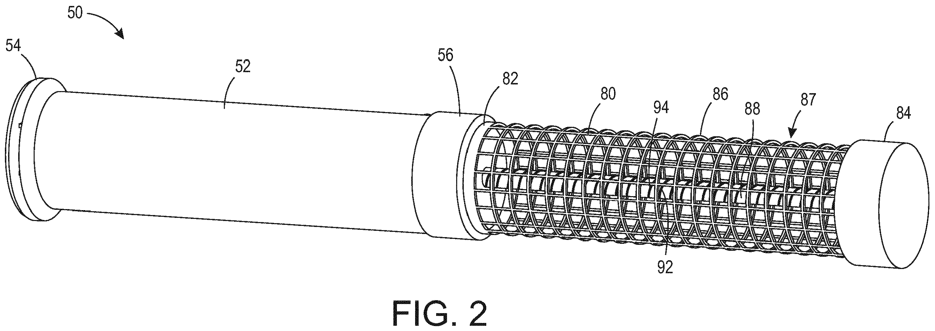

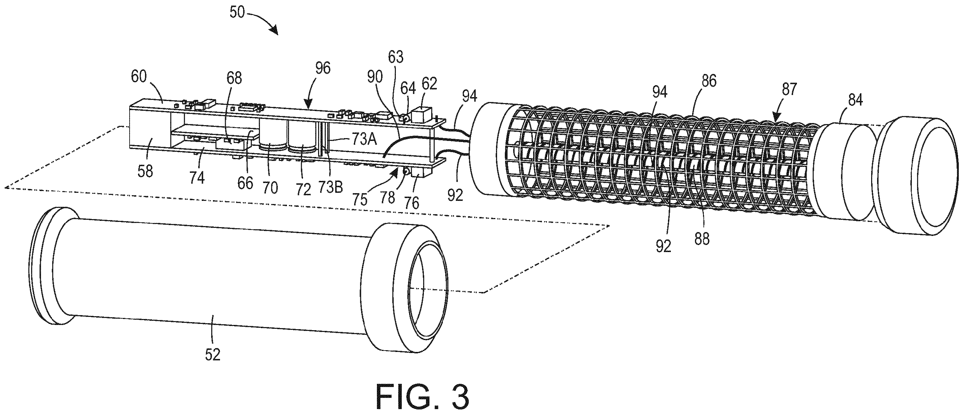

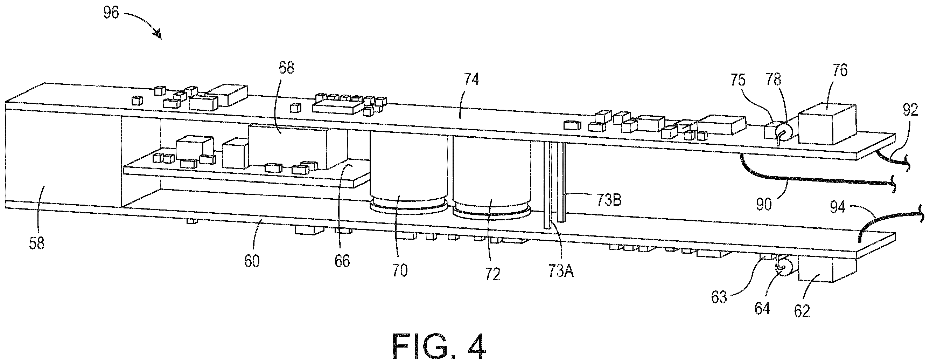

Figure 2 is a top perspective view of sensor **50**, not forming part of the present invention. Figure 3 is an exploded view of sensor 50, not forming part of the present invention. Figure 4 is a perspective view of circuit board assembly **96**. Sensor **50** generally comprises housing **52**, ion sensor **80**, and circuit board assembly **96**. Sensor **50** compares positive and negative ions in the space or room and sends that information to controller **110**. The following description should be read in view of Figures 2-4.

Housing **52** is generally cylindrical and comprises end **54** and end **56**. Housing **52** is preferably a conductive metal shielding that at least partially forms a Faraday shield around circuit board assembly **96**, which is housed therein. A Faraday shield or Faraday cage (as discussed below) is an enclosure used to block electromagnetic fields. A Faraday shield may be formed by a continuous covering of conductive material or in the case of a Faraday cage, by a mesh of such materials. As such, housing **52** prevents interference with the sensitive circuitry of circuit board assembly **96**. In some examples, housing **52** comprises stainless steel. In some embodiments, housing **52** comprises a plastic shell that is internally coated with a metal. End **54** comprises port **58**. Sensor **50** is connected to controller **110** through port **58** via electrical conduit **12**. In some embodiments, port **58** is a RJ 45 connector. However, it should be appreciated that port **58** may comprise any connector suitable for providing an interface between sensor **50** and controller **110**. In some examples, sensor **50** communicates with controller **110** via transmitter **51**.

Ion sensor **80** extends from housing **52**. Ion sensor **80** comprises cage **86** and core 88, both extending between end **82**, connected to end **56**, and end **84**. In some examples, ion sensor **80** does not comprise cage **86**. Ends **82** and **84** may comprise a conductive material, or may comprise plastic or other non-conductive material coated or wrapped in a conductive material such as copper foil. The material of ends **82** and **84** is such that it aids in creating a Faraday cage as discussed further below. Core **88** is a nonconductive core including two interleaved wire helices wrapped therearound. As shown in the figures, wires **92** and **94** are alternatingly wrapped around core **88**, which are connected to circuit board assembly **96**. Specifically, wire **92** is connected to circuit board **74** via any suitable method, for example, soldering. Wire **94** is connected to circuit board **60** via any suitable method, for example, soldering. One of wires **92** and **94** is charged to a voltage of approximately +35V and the other of wires **92** and **94** is charged to a voltage of approximately -35V. However, it should be appreciated that the precise voltage may be adjusted for various reasons, including adjusting sensitivity, calibration, or to accommodate specific requirements of the user. In some examples, wire **92** comprises a positive charge and, when impacted by negative ions, gains electrons. Wire **92** is connected to circuit board **74** which comprises a transimpedance amplifier that converts this ion current into a voltage. Similarly, wire **94** comprises a negative charge and, when impacted by positive ions, loses electrons. Wire **94** is connected to circuit board **60** which comprises a transimpedance amplifier that converts this current to a voltage. It should be appreciated that in some examples, wire **92** may comprise a negative charge and wire **94** may comprise a positive charge. These voltages are filtered, amplified, conditioned, and ultimately digitized by an ADC. The resulting digitized values are processed through proprietary algorithms to produce a result equivalent to the discharge time measured by a CPM. The measurements are also processed through a different proprietary algorithm to determine the DC balance of the ionizing system. If an uncharged CPM is placed in an ionizing stream, ideally, the plate would remain at zero volts with respect to ground, but many ionizers produce a slight imbalance in their ion streams, resulting in the charged plate monitor receiving a small positive or negative charge. This sensor technology can also measure this DC offset, essentially by comparing the results of the positive and negative helix currents. In some examples, wires **92** and **94** are uninsulated, low corrosion, gold plated wires. The double-helix sensor design functions to provide real-time, direct measurement of ion current, and low noise/leakage.

Cage **86** is a metal (conductive) shield having openings **87** to allow airflow to core **88**. Cage **86** forms a Faraday cage which protects wires **92** and **94** from electric fields that would otherwise affect the readings. Cage **86** is connected to the electrical ground plane of the sensor circuit boards, for example, an electrical ground plane (not shown) within circuit board **74**, via wire **90**. It should be appreciated that, cage **86** may be connected to an electrical ground plane located on circuit board **60** via wire **90**. Furthermore, the electrical ground plane in circuit board **74** and the electrical ground plane in circuit board **60** are connected via one or more conductive pins, shown as pins **73A** and **73B**. Pins **73A** and **73B** extend from circuit board **60** to circuit board **74** to electrically connect the ground planes arranged in circuit board **60** and circuit board **74**. The ground planes in circuit boards **60** and **74** help reduce the influence of external noise sources from interrupting the circuitry of circuit board assembly **96**. The ground planes of the circuit boards keep sensitive analog circuits operating at low noise capability. It should be appreciated that any number of pins suitable for connecting the ground planes to reduce the external noise affecting the circuitry may be used. In some examples, cage **86** is arranged as a mesh shield that attenuates external electromagnetic waves before they reach the double helix formed by wires **92** and **94**, yet allows ions to flow therethrough. Openings **87** may comprise a square, hexagonal, circular, or irregular polygon geometry, or any other suitable geometry. In some examples, cage **86** is left ungrounded and is used to measure the offset voltage of the ion stream. In some examples, ion sensor **80** does not comprise cage **86**, but rather only core assembly **88**.

Circuit board assembly **96** generally comprises circuit board **60**, circuit board **74**, and circuit board **66**, which are all connected to port **58**. Circuit boards **60**, **74**, and **66** may be printed circuit boards (PCBs). Power inductor **68** is arranged between circuit board **66** and circuit board **74**. However, power inductor **68** may be arranged at any suitable location relative to circuit boards **66** and **74**. Circuit board **66** and power inductor **68** are arranged to regulate the power supplied to sensor **50**. Circuit board **60** comprises *inter alia,* control relay **62**, gain-control resistor **64**, filter capacitor **63**, and a transimpedance amplifier, and is connected to wire **94**. Circuit board **60** is arranged to convert current in wire **94** to a voltage, and subsequently filter, amplify, condition, and digitize that voltage. Similarly, circuit board **74** comprises *inter alia,* control relay **76**, gain-control resistor **78**, filter capacitor **75**, and a transimpedance amplifier, and is connected to wire **92**. Circuit board **74** is arranged to convert current in wire **92** to a voltage, and subsequently filter, amplify, condition, and digitize that voltage. The digitized sets of data created by circuit boards **60** and/or **74** are then converted to a serial message format and transmitted via RS-485 (or another communication means) to controller **110**. The level of DC balance determined by sensor **50** will be used by controller **110** to send information to an ionizer, adjusting it to ensure optimal protection against electrical charge buildup, as will be discussed in greater detail below.

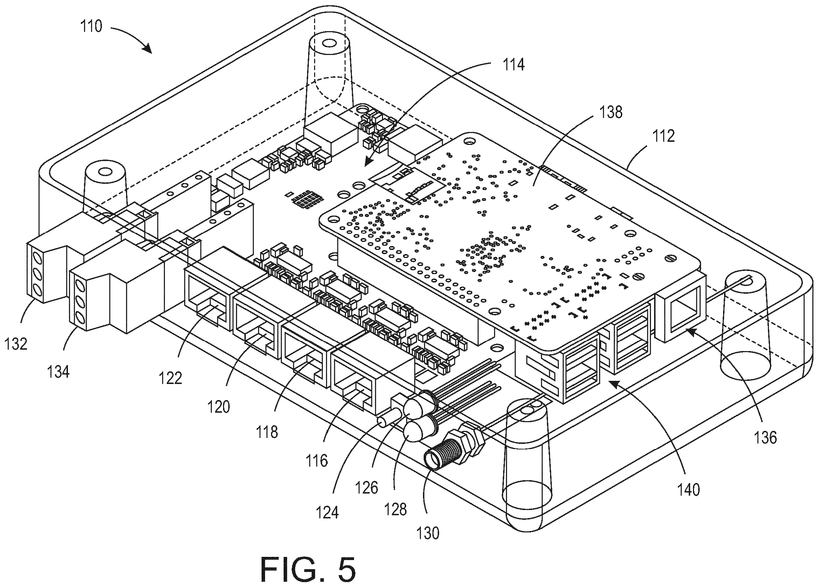

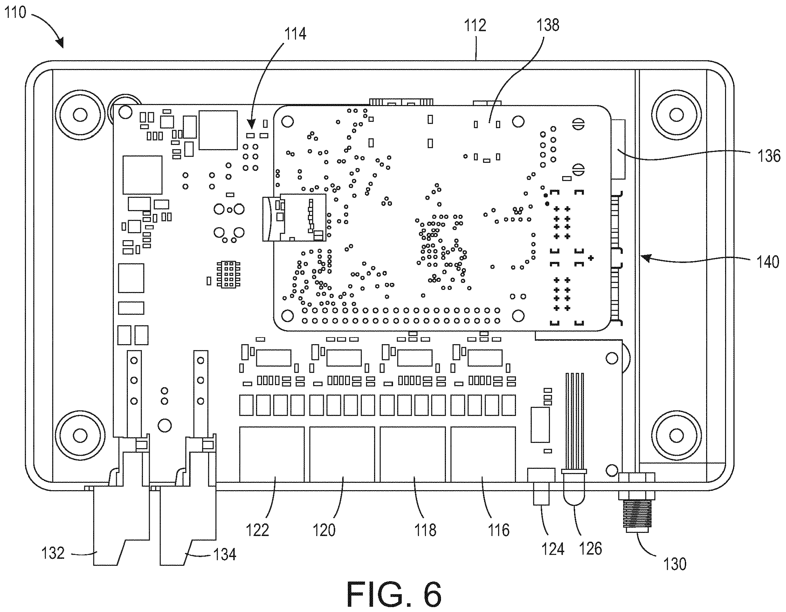

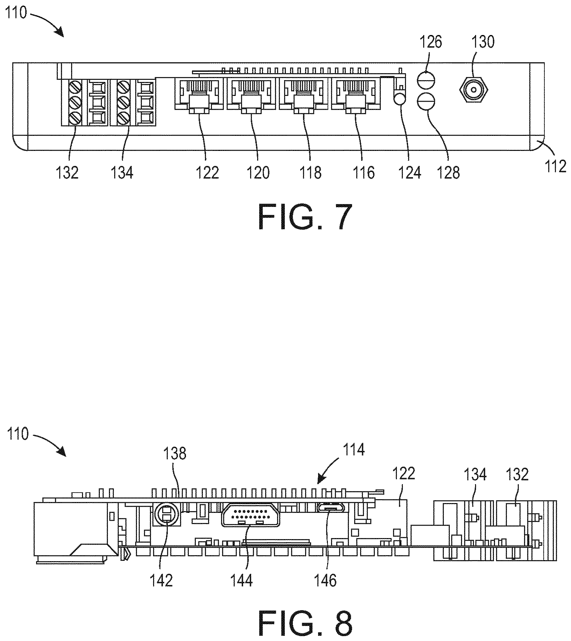

Figure 5 is a perspective view of controller **110**, with a top portion of housing **112** removed for viewing purposes. Figure 6 is a top elevational view of controller **110**. Figure 7 is a front elevational view of controller **110**. Figure 8 is a rear elevational view of controller **110** with housing **112** completely removed for viewing purposes. The following description should be read in view of Figures 5-8.

Controller **110** generally comprises housing **112** which protectively encloses circuit board **114** and data aggregator **138**. Housing **112** comprises bottom portion **112A** and top portion **112B** (not shown). In some embodiments, data aggregator **138** comprises a central processing unit (CPU).

Circuit board **114** comprises event detector port **116**, ionizer port **118**, sensor port **120**, optional port **122**, mode button **124**, indicator lights **126** and **128**, antenna port **130**, power port **132**, and optional communication or trigger port **134**. Controller **110** is supplied power via power port **132**. Mode button **124** allows a user to interact with controller **110**. It should be appreciated that ports **116**, **118**, **120**, and **122** are equivalent and interchangeable, and they also provide power to the peripherals. The peripherals announce to controller **110** what they are when they are plugged in. For example, if sensor **50** is plugged into port **118**, the peripheral tells controller **110** to turn port **118** into a sensor port. The same detection means are included into each of the ports. It should be appreciated that controller **110** may have any suitable number of ports, and the instant invention is not limited to the number of ports illustrated in the figures.

Event detector port **116** is arranged to send a signal or signals to a remote location indicating that ionizer system **10** is not operating normally. If an error has occurred with controller **110**, sensor **50**, whole room ionizer **20**, or individual ionizer **30**, controller **110** sends a signal to indicate such (e.g., if an ionizer or sensor has been damaged). Controller **110** may also send a signal via event detector port **116** to a remote location to indicate the ionizer system **10** is operating normally. Similarly, indicator lights **126** and **128** are arranged for a visual indication of system status. In some embodiments, indicator light **126** is red and indicator light **128** is green. When ionizer system **10** is operating normally, indicator light **128** is on and indicator light **126** is off. When an error has occurred in ionizer system **10**, as discussed above, indicator light **126** is on and indicator light **128** is off. Indicator lights **126** and **128** are preferably light emitting diodes (LEDs); however, it should be appreciated that indicator lights **126** and **128** may be any other suitable light source and any colors suitable for indicating the status of ionizer system **10**. In some embodiments, indicator lights **126** and **128** are red/green/blue LEDs and can indicate any color of the visible spectrum. In some embodiments, controller **110** comprises a speaker and indicates that an error has occurred in ionizing system **10** via an alarm or other suitable noise (e.g., a siren). In some embodiments, the colors indicated by indicator lights **126** and **128** could change back and forth depending on ion balance. In some embodiments, the colors indicated by indicator lights **126** and **128** could show ion strength in a thermometer-style display.

Ionizer port **118** is arranged to physically connect one or more ionizers to controller **110**. For example, whole room ionizer **20** and/or individual ionizer **30** are connected to controller **110** via ionizer port **118**. It should be appreciated that controller **110** may have one or more ionizer ports, and that the embodiment shown is not limited to only one ionizer port. In some embodiments, controller **110** comprises a separate ionizer port for each ionizer in ionizer system **10.** Controller **110** may control all of the ionizers in ionizer system **10** together. For example, if controller **110** receives a signal from sensor **50** that ionizer system **10** needs more positive ions, controller **110** sends a signal to all of the ionizers to produce more positive ions. Controller **110** may control each of the ionizers in ionizer system **10** separately. For example, if controller **110** receives a signal from sensor **50** that machine **2** needs more positive ions, controller **110** sends a signal to only the individual ionizer **30**, and not to whole room ionizer **20**, to produce more positive ions.

Sensor port **120** is arranged to physically connect one or more sensors to controller **110.** For example, sensor **50** is connected to controller **110** via sensor port **120.** It should be appreciated that controller **110** may have one or more sensor ports, and that the embodiment shown is not limited to only one sensor port. In some embodiments, controller **110** comprises a separate sensor port for each sensor in ionizer system **10.** Controller **110** may receive information from all of the sensors in ionizer system **10** together. For example, if controller **110** receives a signal from one sensor that ionizer system **10** needs more positive ions, controller **110** sends a signal to all of the ionizers to produce more positive ions. Controller **110** may receive information from each of the sensors in ionizer system **10** individually and locationally. For example, if controller **110** receives a signal from sensor **50** that machine 2 needs more positive ions, controller **110** sends a signal to only the individual ionizer **30**, and not to whole room ionizer **20**, to produce more positive ions. In some embodiments, sensor port **120** comprises a built in boot loader for programming controller **110**, specifically circuit board **114.**

Antenna port **130** is arranged to physically connect the transducer in controller **110** to an external transmitter or antenna, or an external transmitter having an antenna, either directly or through an extension cable. Specifically, antenna port **130** is arranged to connect to a transmission device or antenna, or a transmission device having an antenna, to transmit information wirelessly to receiver **42** of computing device **40.** In some embodiments, a transmission device may be built directly into controller **110** as will be discussed below. However, antenna port **130** allows for connection to a transmission device that is, for example, outside of the Faraday cage in which controller **110** is located.

Aggregator **138** comprises programming port **136**, Universal Serial Bus (USB) ports **140**, audio/composite video port **142**, High-Definition Multimedia Interface (HDMI) port **144**, and micro Universal Serial Bus (USB) port **146.** Aggregator **138** is arranged a hardware device engineered to extract real-time intersection and traffic cabinet data from interconnected or non-interconnected intersections. In some embodiments, aggregator **138** is a subassembly of controller **110** having a CPU and used as an optional controller.

Controller **110** stores some data short-term (i.e., via aggregator **138**) and feeds the information via a network protocol (e.g., Wi-Fi, Ethernet, or any other suitable means) to computing device **40**, which handles long-term storage of the measurements. A user interface, initially a web browser in a computer, tablet, or mobile device, provides measurements, graphs, and alerts to the user. Cloud connectivity is also an option, enabling enterprise-wide monitoring. Connectivity to other process automation software and hardware will allow improved process control and product manufacturing monitoring, enabling traceability of a particular item back to each manufacturing step, and a log of how effective the anti-static measures were.

Controller **110** receives information from sensor **50**, for example, that there is an imbalance in positive and negative ions. Controller **110** then sends a signal to whole room ionizer **20** and/or individual ionizer **30** to produce either positive or negative ions, whichever are needed. Sensor **50** then sends a signal to controller **110** when there is a balance in positive and negative ions. Controller **110** then sends a signal to whole room ionizer **20** and individual ionizer **30** to stop producing ions or maintain the present ratio. Controller **110** sends information to computing device **40** which is arranged to log data. For example, data may collected regarding the length of time the ionizers run in order to balance the ions in the space or room. If the ionizers need to run for 45 minutes while producing negative ions, but only need to run for 10 minutes while producing positive ions, this may be an indication that the ionizers are not producing negative ions as efficiently as they should be. Additionally or alternatively, this may be an indication that something in the space or room (e.g., a machine) is causing the significant imbalance of positive ions to negative ions, which is resulting in the need for significantly more negative ions. The real-time monitoring and data logging capabilities of ionizer system **10**, specifically through the use of sensor **50**, allows the efficiencies of the ionizers to be determined quickly and effectively, and allows deficiencies in machines or abnormalities in the environment to be detected.

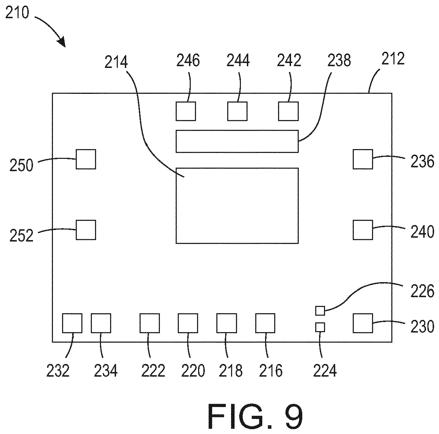

Figure 9 is a schematic view of controller **210**. Controller **210** generally comprises housing **212** which protectively encloses circuit board **214**, data aggregator **238**, receiver **250**, and transmitter **252.** Housing **212** comprises bottom portion **212A** and top portion **212B** (not shown). Receiver **250** receives information wirelessly from a remote location, e.g., computing device **40.** Receiver **250** allows controller **210** to be programmed wirelessly and remotely. Transmitter **252** allows controller **210** to send information wirelessly to a remote location, e.g., computing device **40.** Transmitter **252** may be a replacement for, or additional component to, antenna port **230.**

Circuit board **214** comprises event detector port **216**, ionizer port **218**, sensor port **220**, optional port **222**, mode button **224**, indicator lights **226** and **228**, antenna port **230**, power port **232**, and optional communication or trigger port **234.** Controller **210** is supplied power via power port **232.** Mode button **224** allows a user to interact with controller **210.** It should be appreciated that the various ports are interchangeable and not dedicated to a specific location. Additionally, the various ports can be rededicated to provide for other uses.

Event detector port **216** is arranged to send a signal or signals to a remote location indicating that ionizer system **10** is not operating normally. If an error has occurred with controller **210**, sensor **50**, whole room ionizer **20**, or individual ionizer **30**, controller **210** sends a signal to indicate such (e.g., if an ionizer or sensor has been damaged). Controller **210** may also send a signal via event detector port **216** to a remote location to indicate the ionizer system **10** is operating normally. Similarly, indicator lights **226** and **228** are arranged for a visual indication of system status. In some embodiments, indicator light **226** is red and indicator light **228.** When ionizer system **10** is operating normally, indicator light **228** is on and indicator light **226** is off. When an error has occurred in ionizer system **10**, as discussed above, indicator light **226** is on and indicator light **228** is off. Indicator lights **226** and **228** are preferably light emitting diodes (LEDs); however, it should be appreciated that indicator lights **226** and **228** may be any other suitable light source and any colors suitable for indicating the status of ionizer system **10.** In some embodiments, controller **210** comprises a speaker and indicates that an error has occurred in ionizing system **10** via an alarm or other suitable noise.

Ionizer port **218** is arranged to physically connect one or more ionizers to controller **210.** For example, whole room ionizer **20** and/or individual ionizer **30** are connected to controller **210** via ionizer port **218.** It should be appreciated that controller **210** may have one or more ionizer ports, and that the embodiment shown is not limited to only one ionizer port. In some embodiments, controller **210** comprises a separate ionizer port for each ionizer in ionizer system **10.** Controller **210** may control all of the ionizers in ionizer system **10** together. For example, if controller **210** receives a signal from sensor **50** that ionizer system **10** needs more positive ions, controller **210** sends a signal to all of the ionizers to produce more positive ions. Controller **210** may control each of the ionizers in ionizer system **10** separately. For example, if controller **210** receives a signal from sensor **50** that machine **2** needs more positive ions, controller **210** sends a signal to only the individual ionizer **30**, and not to whole room ionizer **20**, to produce more positive ions.

Sensor port **220** is arranged to physically connect one or more sensors to controller **210.** For example, sensor **50** is connected to controller **210** via sensor port **220.** It should be appreciated that controller **210** may have one or more sensor ports, and that the embodiment shown is not limited to only one sensor port. In some embodiments, controller **210** comprises a separate sensor port for each sensor in ionizer system **10.** Controller **210** may receive information from all of the sensors in ionizer system **10** together. For example, if controller **210** receives a signal from one sensor that ionizer system **10** needs more positive ions, controller **210** sends a signal to all of the ionizers to produce more positive ions. Controller **210** may receive information from each of the sensors in ionizer system **10** individually and locationally. For example, if controller **210** receives a signal from sensor **50** that machine **2** needs more positive ions, controller **210** sends a signal to only the individual ionizer **30**, and not to whole room ionizer **20**, to produce more positive ions. In some embodiments, sensor port **220** comprises a built in boot loader for programming controller **210**, specifically circuit board **214.**

Antenna port **230** is arranged to physically connect controller **210** to a transmitter. Specifically, antenna port **230** is arranged to connect to a transmission device to transmit information wirelessly to receiver **42** of computing device **40.** In some embodiments, a transmission device may be built directly into controller **210** as will be discussed below. However, antenna port **230** allows for connection to a transmission device that is, for example, outside of the Faraday cage in which controller **210** is located. In some embodiments, receiver **250** and transmitter **252** are both connected to antenna port **230**, and antenna port is connected to a transmitter or an antenna, or a transmitter having an antenna, directly or via an extension cable.

Aggregator **238** comprises programming port **236**, Universal Serial Bus (USB) ports **240**, audio/composite video port **242**, High-Definition Multimedia Interface (HDMI) port **244**, and micro Universal Serial Bus (USB) port **246.** Aggregator **238** is arranged a hardware device engineered to extract real-time intersection and traffic cabinet data from interconnected or non-interconnected intersections.

Controller **210** stores some data short-term (i.e., via aggregator **238**) and feeds the information via a network protocol (e.g., Wi-Fi, Ethernet, or any other suitable means) to computing device **40**, which handles long-term storage of the measurements. A user interface, initially a web browser in a computer, tablet, or mobile device, provides measurements, graphs, and alerts to the user. Cloud connectivity is also an option, enabling enterprise-wide monitoring. Connectivity to other process automation software and hardware will allow improved process control and product manufacturing monitoring, enabling traceability of a particular item back to each manufacturing step, and a log of how effective the anti-static measures were.

Controller **210** receives information from sensor **50**, for example, that there is an imbalance in positive and negative ions. Controller **210** then sends a signal to whole room ionizer **20** and/or individual ionizer **30** to produce either positive or negative ions, whichever are needed. Sensor **50** then sends a signal to controller **210** when there is a balance in positive and negative ions. Controller **210** then sends a signal to whole room ionizer **20** and individual ionizer **30** to stop producing ions. Controller **210** sends information to computing device **40** which is arranged to log data. For example, data may collected regarding the length of time the ionizers run in order to balance the ions in the space or room. If the ionizers need to run for 45 minutes while producing negative ions, but only need to run for 10 minutes while producing positive ions, this may be an indication that the ionizers are not producing negative ions as efficiently as they should be. Additionally or alternatively, this may be an indication that something in the space or room (e.g., a machine) is causing the significant imbalance of positive ions to negative ions, which is resulting in the need for significantly more negative ions. The real-time monitoring and data logging capabilities of ionizer system **10**, specifically through the use of sensor **50**, allows the efficiencies of the ionizers to be determined quickly and effectively, and allows deficiencies in machines to be detected.

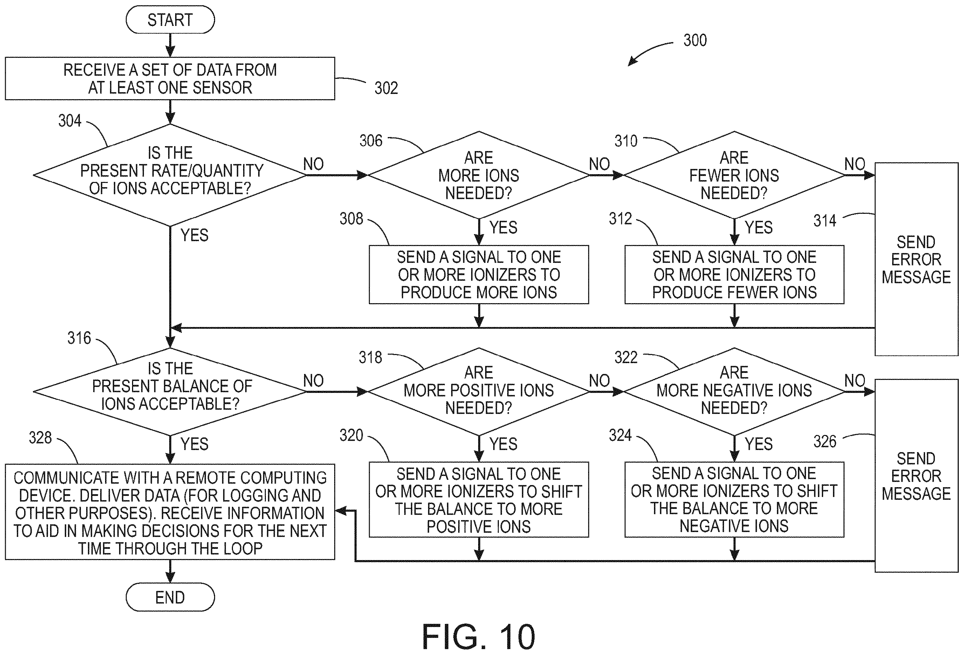

Figure 10 shows flow chart **300** outlining a method of controlling ionizer system **10.** It should be appreciated that flow chart 300 can be utilized with any ionizer system and that this disclosure should not be limited to its use with only ionizer system **10.** The method is performed by controller **110**, which is in communication with whole room ionizer **20**, individual ionizer **30**, sensor **50**, and remote computing device **40.**

In step **302**, controller **50** receives a set of data from sensor **50.** The data may be received via electrical conduit **12** (i.e., hardwired connection) or via a wireless transmission sent by transmitter **51** (i.e., wireless connection).

In step **304**, controller **50** determines if the present rate and/or quantity of ions in the space or room is acceptable. Specifically, the quantity of ions may be measured as the number of ions per volume of space. The rate of ions may be measured as the amount of ions being produced by the ionizers per unit of time.

If the present rate and/or quantity of ions is not acceptable, then in step **306**, controller **50** determines if more ions are needed. If more ions are needed, then in step **308**, controller **50** sends a signal to whole room ionizer **20** and/or individual ionizer **30** to produce more ions. If more ions are not needed, then in step **310**, controller **50** determines if fewer ions are needed. If fewer ions are needed, then in step **312**, controller **50** sends a signal to whole room ionizer **20** and/or individual ionizer **30** to produce fewer ions. If controller **50** determines that the present rate and/or quantity of ions is not acceptable, that more ions are not needed, and that fewer ions are not needed, then in step **314** controller **50** sends a signal that an error in ionizer system **10** has occurred. Controller **50** may, for example, send a signal to a remote location through event detector port **116** and/or indicate a system error via indicator lights **126**/**128**.

If more ions are not needed, then in step **316**, controller **50** determines if there is an ion imbalance in the space or room. Specifically, controller **50** determines if the present balance of ions is acceptable. For example, if the level of positive ions is equal to the level of negative ions, then there is no ion imbalance. If the level of positive ions is not equal to the level of negative ions, then there is an ion imbalance. It should be appreciated that alpha ionizers typically produce a balanced level of ions in the space or room because alpha ionizers are inherently balanced. As such, in some embodiments, alpha ionizers may be used to limit the ion imbalance of ionizer system **10.**

If the present balance of ions is acceptable (i.e., there is no ion imbalance), then in step **328**, controller **50** sends a communication to remote computing device **40.** Computing device **40** logs this communication (i.e., at that particular moment in time there was no ion imbalance). Additionally, if there is no ion imbalance, controller **50** may send a signal to whole room ionizer **20** and/or individual ionizer **30** to produce a balanced quantity of positive and negative ions. It should be appreciated that in step **328**, controller **50** communicates with remote computing device **40** and delivers data to remote computing device **40** for logging and other purposes (e.g., analysis). Additionally in step **328**, controller **50** may receive information to aid in making decision for the next loop of flow chart **300**, for example, receiving updates to the system.

If the present balance of ions is not acceptable (i.e., there is an ion imbalance), then in step **318**, controller **50** determines if more positive ions are needed. If the level of positive ions is less than the level of negative ions, then more positive ions are needed. If the level of positive ions is greater than or equal to the level of negative ions, then more positive ions are not needed.

If more positive ions are needed, then in step **320**, controller **50** sends a signal to whole room ionizer **20** and/or individual ionizer **30** to produce positive ions or shift the balance of ion production to more positive ions.

If more positive ions are not needed, then in step **322**, controller **50** determines if more negative ions are needed. If the level of negative ions is less than the level of positive ions, then more negative ions are needed. If the level of negative ions is greater than or equal to the level of positive ions, then more negative ions are not needed. It should be appreciated that this step may be removed from the method because, if controller **50** determines that there is an ion imbalance in step **316**, and also determines that more positive ions are not needed in step **318**, then by logic more negative ions must be needed (unless there is an error in the system).

If more negative ions are needed, then in step **324**, controller **50** sends a signal to whole room ionizer **20** and/or individual ionizer **30** to produce negative ions or shift the balance of ion production to more negative ions.

If more negative ions are not needed, then in step **326**, controller **50** sends a signal that an error in ionizer system **10** has occurred. Controller **50** may, for example, send a signal to a remote location through event detector port **116** and/or indicate a system error via indicator lights **126/128.**

After controller **50** has sent a signal either in step **308**, step **312**, step **314**, step **320**, step **324**, or step **326**, controller **50** sends a communication to computing device **40** (similar to that as previously discussed with respect to step **228**). Computing device **40** logs the communication. The data that is logged by computing device **40** can then be analyzed and compiled to determine the efficiency of the ionizers, the calibration of the sensors, and any defects in the system producing an excessive charge in the space or room (e.g., a faulty machine).

It should be appreciated that there are various methods of increasing the level of positive ions relative to negative ions and also increasing the level of negative ions relative to positive ions. For example, if more negative ions are needed, controller **50** may stop the production of positive ions and continue to produce negative ions, reduce the production of positive ions and continue to produce negative ions, stop the production of positive ions and increase the production of negative ions, or reduce the production of positive ions and increase the production of negative ions. If more positive ions are needed, controller **50** may stop the production of negative ions and continue to produce positive ions, reduce the production of negative ions and continue to produce positive ions, stop the production of negative ions and increase the production of positive ions, or reduce the production of negative ions and increase the production of positive ions.

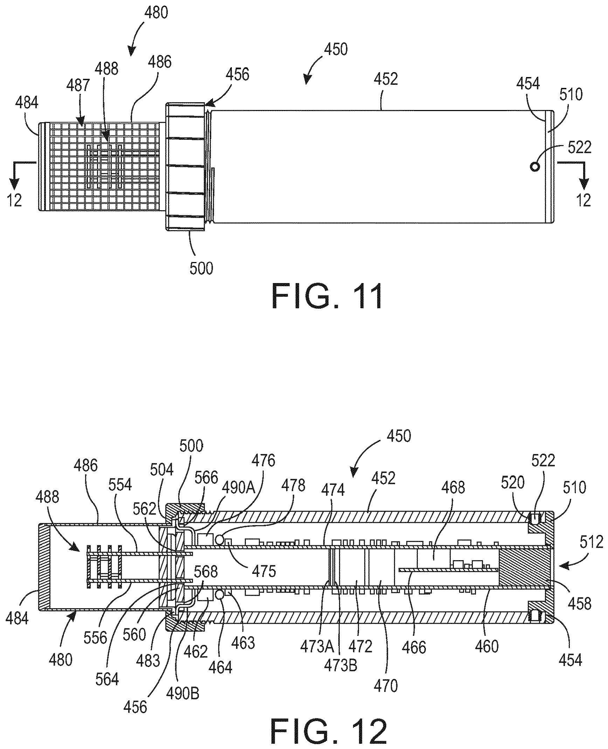

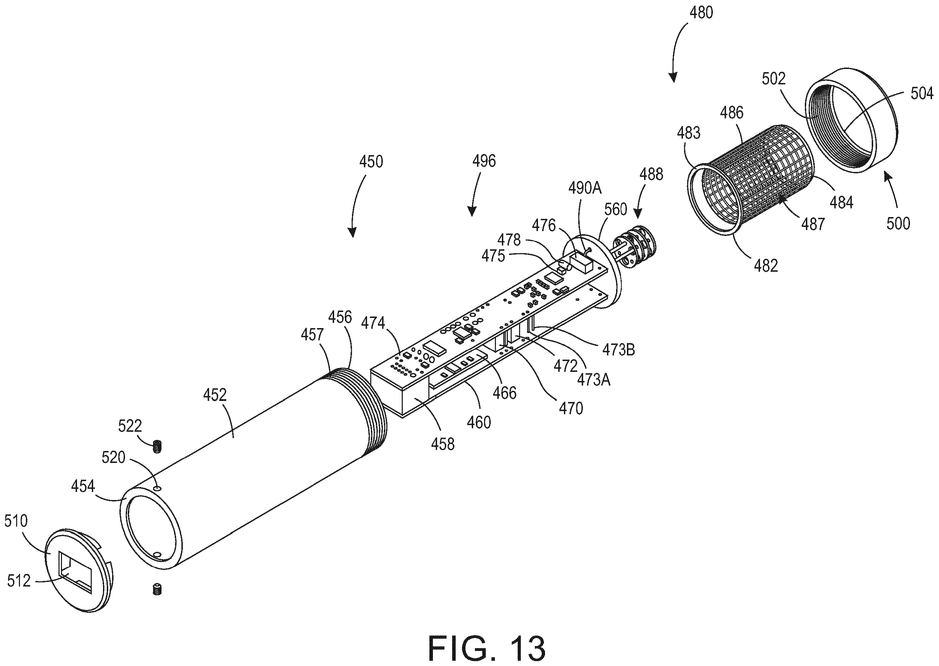

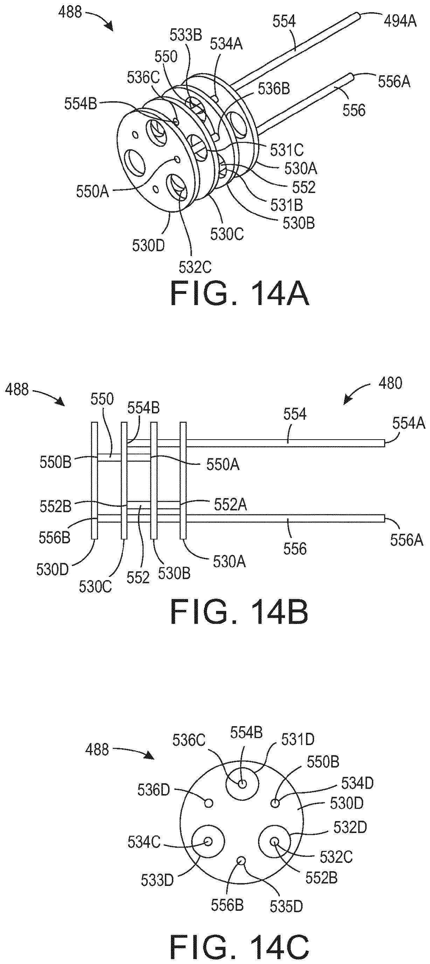

Figure 11 is an elevational view of sensor **450** according to the present invention. Figure 12 is a cross-sectional view of sensor **450**, taken generally along line **12-12** in Figure 11. Figure 13 is an exploded perspective view of sensor **450.** Figure 14A is a perspective view of core assembly **488.** Figure 14B is a side elevational view of core assembly **488.** Figure 14C is a front elevational view of core assembly **480.** Sensor **450** generally comprises housing **452**, ion sensor **480**, and circuit board assembly **496.** Sensor **450** may be used in ionizer system **10** either in place of or in addition to sensor **50.** Sensor **450** performs substantially the same function as sensor **50** and can be implemented in ionizer system **10**, shown in Figure 1, instead of or in addition to sensor **50.** Sensor **450** compares positive and negative ions in the space or room and sends that information to controller **110.** The following description should be read in view of Figures 12-14C.

Housing **452** is generally cylindrical and comprises end **454** and end **456.** Housing **452** is preferably a conductive metal shielding that at least partially forms a Faraday shield around circuit board assembly **496**, which is housed therein. A Faraday shield or Faraday cage (as discussed below) is an enclosure used to block electromagnetic fields. A Faraday shield may be formed by a continuous covering of conductive material or in the case of a Faraday cage, by a mesh of such materials. As such, housing **452** prevents interference with the sensitive circuitry of circuit board assembly **496.** In some embodiments, housing **452** comprises stainless steel. In some embodiments, housing **452** comprises a plastic shell that is internally coated with a metal. End **454** comprises port **458.** Sensor **450** is connected to controller **110** through port **458** via electrical conduit **12.** In some embodiments, port **458** is a RJ 45 connector. However, it should be appreciated that port **458** may comprise any connector suitable for providing an interface between sensor **450** and controller **110.** In some embodiments, sensor **450** communicates with controller **110** via transmitter **51.** Sensor **450** may further comprise cap **510** which is removably connected to end **454.** Cap **510** comprises opening **512** which allows electrical connection to port **458.** In some embodiments, cap **510** is connected to end **450** via one or more set screws **522** engaged in one or more holes **520.** In some embodiments, cap **510** is connected to end **450** via an interference or friction fit. Sensor **450** may further comprise threading **457** proximate end **456.**

Ion sensor **480** extends from housing **452.** Ion sensor **480** comprises cage **486** and core assembly **488.** Cage **486** is connected to end **456** via, for example, nut **500.** Cage **486** comprises end **482** including flange **483** and end **484.** In some embodiments, ion sensor **480** does not comprise cage **486.** Nut **500** comprises threading **502** and flange **504.** Flange **483** is arranged to abut against end **456** or plate **560.** Nut **500** is then secured to housing **452**, namely, threading **502** engages threading **457** and flange **504** clamps flange **483** against end **456** and/or plate **560.** It should be appreciated that any suitable method for securing cage **486** to housing **456** may be used, for example, set screws, adhesives, soldering, welding, bolts, etc. The material of cage **486** is such that it aids in creating a Faraday cage as discussed further below.

Core assembly **488** comprises one or more plates and a plurality of rods. Specifically, core assembly comprises plates **530A-D** and rods **550, 552, 554,** and **556.** It should be appreciated, however, that core assembly **488** may comprise any number of plates and rods suitable for measuring ionic charge. As shown in the figures, plates **530A-D** are arranged adjacent each other and are substantially the same. Plate **530A** comprises holes **531A, 532A, 533A, 534A, 535A,** and **536A.** Plate **530B** comprises holes **531B, 532B, 533B, 534B, 535B,** and **536B.** Plate **530C** comprises holes **531C, 532C, 533C, 534C, 535C,** and **536C.** Plate **530D** comprises holes **531D, 532D, 533D, 534D, 535D,** and **536D.** As shown in Figure 14C, holes **531D, 532D,** and **533D** are larger than holes **534D, 535D,** and **536D.** Plates **530A-C** include this same arrangement with respect to their respective holes. Smaller holes **534D, 535D,** and **536D** are arranged for connection to respective rods, whereas larger holes **531D, 532D,** and **533D** must be large enough such that respective rods can pass therethrough and charge in plate/rod does not leak into the passthrough rod/plate. Specifically, rod **554** comprises ends **554A** and **554B.** Rod **554** is connected to plate **530A** at a point between ends **554A** and **554B,** passes through larger hole **533B** in plate **530B,** and is connected to plate **530C** at end **554B.** Rod **554** may be connected to plates **530A** and **530C** via any suitable method, such as soldering, welding, adhesives, interference or friction fit, etc. The clearance between rod **554** and plate **530B** formed by larger hole **533B** prevents any significant transfer of charge therebetween. Rod **556** comprises ends **556A** and **556B.** Rod **556** passes through larger hole **533A** in plate **530A,** is connected to plate **530B** at a point between ends **556A** and **556B,** passes through larger hole **532C** in plate **530C,** and is connected to plate **530D** at end **556B.** Rod **556** may be connected to plates **530B** and **530D** via any suitable method, such as soldering, welding, adhesives, interference or friction fit, etc. The clearance between rod **556** and plate **530A** formed by larger hole **533A** and between rod **556** and plate **530C** formed by hole **532C** prevents any significant transfer of charge therebetween. Rod **550** comprises ends **550A** and **550B.** Rod **550** is connected to plate **530B** at end **550A**, passes through larger hole **531C** in plate **530C**, and is connected to plate **530D** at end **550B.** Rod **550** may be connected to plates **530B** and **530D** via any suitable method, such as soldering, welding, adhesives, interference or friction fit, etc. The clearance between rod **550** and plate **530C** formed by larger hole **531C** prevents any significant transfer of charge therebetween. Rod **552** comprises ends **552A** and **552B.** Rod **552** is connected to plate **530A** at end **552A**, passes through larger hole **531B** in plate **530B**, and is connected to plate **530C** at end **552B**. Rod **552** may be connected to plates **530A** and **530C** via any suitable method, such as soldering, welding, adhesives, interference or friction fit, etc. The clearance between rod **552** and plate **530B** formed by larger hole **531B** prevents any significant transfer of charge therebetween. It should be appreciated, that rods 554 and **556** do not need to be rigid bars, but can instead be any suitable electrical conductor, for example, wires. In some embodiments, core assembly **488** does not comprise any plates, and instead only comprises rod or electrical conductor **554** and rod or electrical conductor **556**. In some embodiments, core assembly **488** comprises one or more plates. For example, in some embodiments core assembly **488** comprises sixteen plates arranged adjacent each other. In this example embodiment, from right to left as in the arrangement of Figure 14B (can be visualized as plates **530A-P**), the first, third, fifth, seventh, ninth, eleventh, thirteenth, and fifteenth plates are connected to rod **554** and rod **552**. The second, fourth, sixth, eighth, tenth, twelfth, fourteenth, and sixteenth plates are connected to rod **556** and rod **550**.

Respectively connected rods and plates are charged with a voltage. For example, rod **554**, rod **552**, plate **530A**, and plate **530C** are electrically connected and form a first line. Rod **556**, rod **550**, plate **530B**, and plate **530D** are electrically connected and form a second line. One of the first and second lines (e.g., first line: rod **554**, rod **552**, plate **530A**, and plate **530C**) is charged to a voltage of approximately +35V and the other of the first and second lines (e.g., second line: rod **556**, rod **550**, plate **530B**, and plate **530D**) is charged to a voltage of approximately -35V. However, it should be appreciated that the precise voltage may be adjusted for various reasons, including adjusting sensitivity, calibration, or to accommodate specific requirements of the user. In some embodiments, the first line (i.e., rod **554**, rod **552**, plate **530A**, and plate **530C**) comprises a positive charge and, when impacted by negative ions, gains electrons. The first line, specifically, rod **554**, is connected to circuit board **474** which comprises a transimpedance amplifier that converts this ion current into a voltage. Similarly, the second line (i.e., rod **556**, rod **550**, plate **530B**, and plate **530D**) comprises a negative charge and, when impacted by positive ions, loses electrons. The second line, specifically, rod **556**, is connected to circuit board **460** which comprises a transimpedance amplifier that converts this current to a voltage. It should be appreciated that in some embodiments, first line (i.e., rod **554**, rod **552**, plate **530A**, and plate **530C**) may comprise a negative charge and the second line (i.e., rod **556**, rod **550**, plate **530B**, and plate **530D**) may comprise a positive charge. These voltages are filtered, amplified, conditioned, and ultimately digitized by an ADC. The resulting digitized values are processed through proprietary algorithms to produce a result equivalent to the discharge time measured by a CPM. The measurements are also processed through a different proprietary algorithm to determine the DC balance of the ionizing system. If an uncharged CPM is placed in an ionizing stream, ideally, the plate would remain at zero volts with respect to ground, but many ionizers produce a slight imbalance in their ion streams, resulting in the charged plate monitor receiving a small positive or negative charge. This sensor technology can also measure this DC offset, essentially by comparing the results of the positive and negative helix currents. In some embodiments, rod **554** engages plate **560**, specifically hole **562**, and is electrically connected to circuit board **474** via, for example, wire **492** (not shown). Rod **556** engages plate **560**, specifically hole **564**, and is electrically connected to circuit board **460** via, for example, wire **494** (not shown). It should be appreciated that rods **554** and **556** may be electrically connected to circuit boards **474** and **460**, respectively, via any suitable means. In some embodiments, wires **492** and **494** are uninsulated, low corrosion, gold plated wires. Wire **492** is connected to circuit board **474** via any suitable method, for example, soldering. Wire **494** is connected to circuit board **460** via any suitable method, for example, soldering. The core assembly ion sensor design of the present disclosure functions to provide real-time, direct measurement of ion current, and low noise/leakage.

Cage **486** is a metal (conductive) shield having openings **487** to allow airflow to core assembly **488**. Cage **486** forms a Faraday cage which protects rod **550**, rod **552**, rod **554**, rod **556**, and plates **530A-D** from electric fields that would otherwise affect the readings. Cage **486** is connected to the electrical ground plane of the sensor circuit boards, for example, an electrical ground plane (not shown) within circuit board **474**, via wire **490A** and/or an electrical ground plane (not shown) within circuit board **460**, via wire **490B**. As shown, a first end of wire **490A** is arranged between (e.g., clamped between) flange **483** of cage **486** and plate **560**, extends through hole **566** in plate **560**, and a second end of wire **490A** is connected to the electrical ground plane of circuit board **474**. Similarly, a first end of wire **490B** is arranged between (e.g., clamped between) flange **483** of cage **486** and plate **560**, extends through hole **568** in plate **560**, and a second end of wire **490B** is connected to the electrical ground plane of circuit board **460**. Furthermore, the electrical ground plane in circuit board **474** and the electrical ground plane in circuit board **460** are connected via one or more conductive pins, shown as pins **473A** and **473B.** Pins **473A** and **473B** extend from circuit board **460** to circuit board **474** to electrically connect the ground planes arranged in circuit board **460** and circuit board **474.** The ground planes in circuit boards **460** and **474** help reduce the influence of external noise sources from interrupting the circuitry of circuit board assembly **496.** The ground planes of the circuit boards keep sensitive analog circuits operating at low noise capability. It should be appreciated that any number of pins suitable for connecting the ground planes to reduce the external noise affecting the circuitry may be used. In some embodiments, cage **486** is arranged as a mesh shield that attenuates external electromagnetic waves before they reach core assembly **488**, yet allows ions to flow therethrough. Openings **487** may comprise a square, hexagonal, circular, or irregular polygon geometry, or any other suitable geometry. In some embodiments, cage **486** is left ungrounded and is used to measure the offset voltage of the ion stream. In some embodiments, ion sensor **480** does not comprise cage **486**, but rather only core assembly **488.**

Circuit board assembly **496** generally comprises circuit board **460**, circuit board **474**, and circuit board **466**, which are all connected to port **458**. Circuit boards **460**, **474**, and **466** may be printed circuit boards (PCBs). Power inductor **468** is arranged between circuit board **466** and circuit board **474**. However, power inductor **468** may be arranged at any suitable location relative to circuit boards **466** and **474**. Circuit board **466** and power inductor **468** are arranged to regulate the power supplied to sensor **450**. Circuit board **460** comprises *inter alia,* control relay **462**, gain-control resistor **464**, filter capacitor **463**, and a transimpedance amplifier, and is connected to wire **490B** and rod **556.** Circuit board **460** is arranged to convert current in rod **556** to a voltage, and subsequently filter, amplify, condition, and digitize that voltage. Similarly, circuit board **474** comprises *inter alia,* control relay **476**, gain-control resistor **478**, filter capacitor **475**, and a transimpedance amplifier, and is connected to wire **490A** and rod **554.** Circuit board **474** is arranged to convert current in rod **554** to a voltage, and subsequently filter, amplify, condition, and digitize that voltage. The digitized sets of data created by circuit boards **460** and/or **474** are then converted to a serial message format and transmitted via RS-485 (or another communication means) to controller **110**. The level of DC balance determined by sensor **450** will be used by controller **110** to send information to an ionizer, adjusting it to ensure optimal protection against electrical charge buildup, as previously discussed. It should be appreciated that sensor **450** interacts with controller **110** either via hardwire or transmitter **51** is substantially the same way as sensor **50**.

### REFERENCE NUMERALS

- **2**: Machine
- **10**: Ionizer system
- **12**: Electrical conduit
- **20**: Whole room ionizer
- **22**: Receiver
- **30**: Individual ionizer
- **32**: Receiver
- **40**: Computing device
- **42**: Receiver
- **44**: Transmitter
- **50**: Sensor
- **51**: Transmitter
- **52**: Housing
- **54**: End
- **56**: End
- **58**: Port
- **60**: Circuit board
- **62**: Control relay
- **63**: Filter capacitor
- **64**: Gain-control resistor
- **66**: Circuit board
- **68**: Power Inductor
- **70**: Capacitor
- **72**: Capacitor
- **73A**: Pin
- **73B**: Pin
- **74**: Circuit board
- **75**: Filter capacitor
- **76**: Control relay
- **78**: Gain-control resistor
- **80**: Ion sensor
- **82**: End
- **84**: End
- **86**: Cage
- **87**: Openings
- **88**: Core
- **90**: Wire
- **92**: Wire
- **94**: Wire
- **96**: Circuit board assembly
- **110**: Controller
- **112**: Housing
- **112A**: Bottom portion
- **112B**: Top portion (not shown)
- **114**: Circuit board
- **116**: Event detector port
- **118**: Ionizer port
- **120**: Sensor port
- **122**: Optional port
- **124**: Mode button
- **126**: Indicator light
- **128**: Indicator light
- **130**: Antenna port
- **132**: Power port
- **134**: Optional communication port
- **136**: Programming port
- **138**: Data aggregator
- **140**: Universal Serial Bus (USB) ports
- **142**: Audio/composite video port
- **144**: High-Definition Multimedia Interface (HDMI) port
- **146**: Micro Universal Serial Bus (USB) port
- **210**: Controller
- **212**: Housing
- **212A**: Bottom portion
- **212B**: Top portion
- **214**: Circuit board
- **216**: Event detector port
- **218**: Ionizer port
- **220**: Sensor port
- **222**: Optional port
- **224**: Mode button
- **226**: Indicator light
- **228**: Indicator light
- **230**: Antenna port
- **232**: Power port
- **234**: Optional communication port
- **236**: Programming port
- **238**: Data aggregator
- **240**: Universal Serial Bus (USB) ports
- **242**: Audio/composite video port
- **244**: High-Definition Multimedia Interface (HDMI) port
- **246**: Micro Universal Serial Bus (USB) port
- **250**: Receiver
- **252**: Transmitter
- **300**: Flow chart
- **302**: Step
- **304**: Step
- **306**: Step
- **308**: Step
- **310**: Step
- **312**: Step
- **314**: Step
- **316**: Step
- **318**: Step
- **320**: Step
- **322**: Step
- **324**: Step
- **326**: Step
- **328**: Step
- **450**: Sensor
- **451**: Transmitter (not shown)
- **452**: Housing
- **454**: End
- **456**: End
- **557**: Threading
- **458**: Port
- **460**: Circuit board
- **462**: Control relay
- **463**: Filter capacitor
- **464**: Gain-control resistor
- **466**: Circuit board
- **468**: Power Inductor
- **470**: Capacitor
- **472**: Capacitor
- **473A**: Pin
- **473B**: Pin
- **474**: Circuit board
- **475**: Filter capacitor
- **476**: Control relay
- **478**: Gain-control resistor
- **480**: Ion sensor
- **482**: End
- **483**: Flange
- **484**: End
- **486**: Cage
- **487**: Openings
- **488**: Core assembly
- **490A**: Wire
- **490B**: Wire
- **492**: Wire (not shown)
- **494**: Wire (not shown)
- **496**: Circuit board assembly
- **500**: Nut
- **502**: Threading
- **504**: Flange
- **510**: Cap
- **512**: Opening
- **520**: Hole(s)
- **522**: Screw(s)
- **530A**: Plate
- **531A**: Hole
- **532A**: Hole
- **533A**: Hole
- **534A**: Hole
- **535A**: Hole
- **536A**: Hole
- **530B**: Plate
- **531B**: Hole
- **532B**: Hole
- **533B**: Hole
- **534B**: Hole
- **535B**: Hole
- **536B**: Hole
- **530C**: Plate
- **531C**: Hole
- **532C**: Hole
- **533C**: Hole
- **534C**: Hole
- **535C**: Hole
- **536C**: Hole
- **530D**: Plate
- **531D**: Hole
- **532D**: Hole
- **533D**: Hole
- **534D**: Hole
- **535D**: Hole
- **536D**: Hole
- **550**: Rod
- **550A**: End
- **550B**: End
- **552**: Rod
- **552A**: End
- **552B**: End
- **554**: Rod
- **554A**: End
- **554B**: End
- **556**: Rod
- **556A**: End
- **556B**: End
- **560**: Plate
- **562**: Hole
- **564**: Hole
- **566**: Hole
- **568**: Hole

## Claims

1. A sensor (450) for sensing ions, comprising:
a circuit board assembly (496); and,
a core assembly (488) connected to the circuit board assembly (496), the core assembly (488) including a first electrical conductor (554) and a second electrical conductor (556);
the circuit board assembly (496) comprising:
a first circuit board (474); and,
a second circuit board (460);
the first electrical conductor (554) connected to the first circuit board (474);
the second electrical conductor (556) connected to the second circuit board (460); the core assembly (488) further comprising:
a first plate (530A) including a first hole (534A) engaged with the first electrical conductor (554) and a second hole (533A) engaged with the second electrical conductor (556), wherein the first electrical conductor (554) and the first plate (530A) are configured to be charged with a positive voltage and operatively arranged to collect negative ions; and,
a second plate (530B) arranged adjacent to the first plate (530A), the second plate (530B) including a third hole (533B) engaged with the first electrical conductor (554) and a fourth hole (534B) engaged with the second electrical conductor (556), wherein the second electrical conductor (556) and the second plate (530B) are configured to be charged with a negative voltage and operatively arranged to collect positive ions.

2. The sensor (450) as recited in claim 1, further comprising a housing (452) at least partially enclosing the circuit board assembly (496), the housing (452) including a first end (454) and a second end (456).

3. The sensor (450) as recited in any of the preceding claims, further comprising a port (458) connected to the circuit board assembly (496), the port arranged proximate the first end (454).

4. The sensor (450) as recited in any of the preceding claims, further comprising a cage (486) at least partially surrounding the core assembly (488) and electrically connected to the circuit board assembly (496).

5. The sensor (450) as recited in any of the preceding claims, wherein the circuit board assembly (496) further comprises a third circuit board (466).

6. The sensor (450) as recited in claim 4 or 5, wherein the cage (486) is electrically connected to a ground plane of at least one of the first circuit board (474) and the second circuit board (460).

7. The sensor (450) as recited in any of the preceding claims, wherein the core assembly (488) further comprises:
a third plate (530C) arranged adjacent to the second plate (530B) and connected to the first electrical conductor (554); and,
a fourth plate (530D) arranged adjacent to the third plate (530C) and connected to the second electrical conductor (556).

8. The sensor (450) as recited in claim 7, wherein the first plate (530A), the second plate (530B), the third plate (530C), and the fourth plate (530D) are all arranged parallel to each other.

9. The sensor (450) as recited in claim 7 or 8, further comprising:
a third electrical conductor (550) electrically connected to the second plate (530B) and the fourth plate (530D), the third electrical conductor (550) and the fourth plate (530D) are charged with a negative voltage and operatively arranged to collect positive ions; and,
a fourth electrical conductor (552) electrically connected to the first plate (530A) and the third plate (530C), the fourth electrical conductor (552) and the third plate (530C) are charged with a positive voltage and operatively arranged to collect negative ions.

10. The sensor (450) as recited in any of the preceding claims, wherein the first electrical conductor (554) and the second electrical conductor (556) are rods.

11. The sensor (450) as recited in any of the claims 1 to 9, wherein the first electrical conductor (554) and the second electrical conductor (556) are wires.

12. The sensor (450) as recited in any of the claims 4 to 11, wherein the cage (486) is secured to the housing (452).

13. The sensor (450) as recited in any of the claims 7 to 12, wherein:
the third electrical conductor (550) is engaged with the second plate (530B), the third plate (530C), and the fourth plate (530D); and,
the fourth electrical conductor (552) is engaged with the first plate (530A), the second plate (530B), and the third plate (530C).

14. The sensor (450) as recited in any of the claims 7 to 13, wherein the first electrical conductor (554) and/or the second electrical conductor (556) passes through each of the first plate (530A), the second plate (530C), the third plate (530B), and the fourth plate (530D).

15. The sensor (450) as recited in any of the preceding claims,
wherein the core assembly (488) is arranged on a first axial side of a support plate (560) and the circuit board assembly (496) is arranged on a second axial side of the support plate (560), opposite the first axial side;
wherein in an optional configuration, the first electrical conductor (554) passes through the support plate (560) to connect to the first circuit board (474) and the second electrical conductor (556) passes through the support plate (560) to connect to the second circuit board (460).

## Patentansprüche

1. Sensor (450) zum Erfassen von Ionen, umfassend:
eine Leiterplattenbaugruppe (496); und
eine Kernbaugruppe (488), die mit der Leiterplattenbaugruppe (496) verbunden ist, wobei die Kernbaugruppe (488) einen ersten elektrischen Leiter (554) und einen zweiten elektrischen Leiter (556) aufweist;
wobei die Leiterplattenbaugruppe (496) umfasst:
eine erste Leiterplatte (474); und
eine zweite Leiterplatte (460);
wobei der erste elektrische Leiter (554) mit der ersten Leiterplatte (474) verbunden ist;
wobei der zweite elektrische Leiter (556) mit der zweiten Leiterplatte (460) verbunden ist;
wobei die Kernbaugruppe (488) zudem umfasst:
eine erste Platte (530A), die ein erstes Loch (534A) aufweist, das mit dem ersten elektrischen Leiter (554) in Eingriff steht, und ein zweites Loch (533A) aufweist, das mit dem zweiten elektrischen Leiter (556) in Eingriff steht, wobei der erste elektrische Leiter (554) und die erste Platte (530A) dazu konfiguriert sind, mit einer positiven Spannung geladen zu werden, und betriebswirksam angeordnet sind, um negative Ionen zu sammeln; und
eine zweite Platte (530B), die angrenzend an die erste Platte (530A) angeordnet ist, wobei die zweite Platte (530B) ein drittes Loch (533B) aufweist, das mit dem ersten elektrischen Leiter (554) in Eingriff steht, und ein viertes Loch (534B) aufweist, das mit dem zweiten elektrischen Leiter (556) in Eingriff steht, wobei der zweite elektrische Leiter (556) und die zweite Platte (530B) dazu konfiguriert sind, mit einer negativen Spannung geladen zu werden, und betriebswirksam angeordnet sind, um positive Ionen zu sammeln.

2. Sensor (450) nach Anspruch 1, zudem umfassend ein Gehäuse (452), das die Leiterplattengbaugruppe (496) mindestens teilweise umschließt, wobei das Gehäuse (452) ein erstes Ende (454) und ein zweites Ende (456) aufweist.

3. Sensor (450) nach einem der vorhergehenden Ansprüche, zudem umfassend einen Anschluss (458), der mit der Leiterplattenbaugruppe (496) verbunden ist, wobei der Anschluss in der Nähe des ersten Endes (454) angeordnet ist.

4. Sensor (450) nach einem der vorhergehenden Ansprüche, zudem umfassend einen Käfig (486), der die Kernbaugruppe (488) mindestens teilweise umgibt und mit der Leiterplattenbaugruppe (496) elektrisch verbunden ist.

5. Sensor (450) nach einem der vorhergehenden Ansprüche, wobei die Leiterplattenbaugruppe (496) zudem eine dritte Leiterplatte (466) umfasst.

6. Sensor (450) nach Anspruch 4 oder 5, wobei der Käfig (486) mit einer Massefläche von mindestens einer der ersten Leiterplatte (474) und der zweiten Leiterplatte (460) elektrisch verbunden ist.

7. Sensor (450) nach einem der vorhergehenden Ansprüche, wobei die Kernbaugruppe (488) zudem umfasst.
eine dritte Platte (530C), die angrenzend an die zweite Platte (530B) angeordnet ist und mit dem ersten elektrischen Leiter (554) verbunden ist; und
eine vierte Platte (530D), die angrenzend an die dritte Platte (530C) angeordnet ist und mit dem zweiten elektrischen Leiter (556) verbunden ist.

8. Sensor (450) nach Anspruch 7, wobei die erste Platte (530A), die zweite Platte (530B), die dritte Platte (530C) und die vierte Platte (530D) alle parallel zueinander angeordnet sind.

9. Sensor (450) nach Anspruch 7 oder 8, zudem umfassend:
einen dritten elektrischen Leiter (550), der mit der zweiten Platte (530B) und der vierten Platte (530D) elektrisch verbunden ist, wobei der dritte elektrische Leiter (550) und die vierte Platte (530D) mit einer negativen Spannung geladen werden und betriebswirksam angeordnet sind, um positive Ionen zu sammeln; und
einen vierten elektrischen Leiter (552), der mit der ersten Platte (530A) und der dritten Platte (530C) elektrisch verbunden ist, wobei der vierte elektrische Leiter (552) und die dritte Platte (530C) mit einer positiven Spannung geladen werden und betriebswirksam angeordnet sind, um negative Ionen zu sammeln.

10. Sensor (450) nach einem der vorhergehenden Ansprüche, wobei der erste elektrische Leiter (554) und der zweite elektrische Leiter (556) Stäbe sind.

11. Sensor (450) nach einem der Ansprüche 1 bis 9, wobei der erste elektrische Leiter (554) und der zweite elektrische Leiter (556) Drähte sind.

12. Sensor (450) nach einem der Ansprüche 4 bis 11, wobei der Käfig (486) an dem Gehäuse (452) gesichert ist.

13. Sensor (450) nach einem der Ansprüche 7 bis 12, wobei:
der dritte elektrische Leiter (550) mit der zweiten Platte (530B), der dritten Platte (530C) und der vierten Platte (530D) in Eingriff steht; und
der vierte elektrische Leiter (552) mit der ersten Platte (530A), der zweiten Platte (530B) und der dritten Platte (530C) in Eingriff steht.

14. Sensor (450) nach einem der Ansprüche 7 bis 13, wobei der erste elektrische Leiter (554) und/oder der zweite elektrische Leiter (556) durch jede der ersten Platte (530A), der zweiten Platte (530B), der dritten Platte (530C) und der vierten Platte (530D) verläuft.

15. Sensor (450) nach einem der vorhergehenden Ansprüche, wobei die Kernbaugruppe (488) auf einer ersten axialen Seite einer Stützplatte (560) angeordnet ist und die Leiterplattenbaugruppe (496) auf einer zweiten axialen Seite der Stützplatte (560) gegenüber der ersten axialen Seite angeordnet ist;
wobei in einer optionalen Konfiguration der erste elektrische Leiter (554) durch die Stützplatte (560) verläuft, um sich mit der ersten Leiterplatte (474) zu verbinden, und der zweite elektrische Leiter (556) durch die Stützplatte (560) verläuft, um sich mit der zweiten Leiterplatte (460) zu verbinden.

## Revendications

1. Capteur (450) pour détecter des ions, comprenant :
un ensemble de cartes de circuit imprimé (496) ; et,
un ensemble noyau (488) connecté à l'ensemble de cartes de circuit imprimé (496), l'ensemble noyau (488) incluant un premier conducteur électrique (554) et un deuxième conducteur électrique (556) ;
l'ensemble de cartes de circuit imprimé (496) comprenant :
une première carte de circuit imprimé (474) ; et,
une deuxième carte de circuit imprimé (460) ;
le premier conducteur électrique (554) connecté à la première carte de circuit imprimé (474) ;
le deuxième conducteur électrique (556) connecté à la deuxième carte de circuit imprimé (460) ;
l'ensemble noyau (488) comprenant en outre :
une première plaque (530A) incluant un premier trou (534A) engagé avec le premier conducteur électrique (554) et un deuxième trou (533A) engagé avec le deuxième conducteur électrique (556), dans lequel le premier conducteur électrique (554) et la première plaque (530A) sont configurés pour être chargés avec une tension positive et agencés de manière opérationnelle pour collecter des ions négatifs ; et,
une deuxième plaque (530B) agencée de manière adjacente à la première plaque (530A), la deuxième plaque (530B) incluant un troisième trou (533B) engagé avec le premier conducteur électrique (554) et un quatrième trou (534B) engagé avec le deuxième conducteur électrique (556), dans lequel le deuxième conducteur électrique (556) et la deuxième plaque (530B) sont configurés pour être chargés avec une tension négative et agencés de manière opérationnelle pour collecter des ions positifs.

2. Capteur (450) selon la revendication 1, comprenant en outre un boîtier (452) renfermant au moins partiellement l'ensemble de cartes de circuit imprimé (496), le boîtier (452) incluant une première extrémité (454) et une seconde extrémité (456).

3. Capteur (450) selon l'une quelconque des revendications précédentes, comprenant en outre un port (458) connecté à l'ensemble de cartes de circuit imprimé (496), le port étant disposé à proximité de la première extrémité (454).

4. Capteur (450) selon l'une quelconque des revendications précédentes, comprenant en outre une cage (486) entourant au moins partiellement l'ensemble noyau (488) et connectée électriquement à l'ensemble de cartes de circuit imprimé (496).

5. Capteur (450) selon l'une quelconque des revendications précédentes, dans lequel l'ensemble de cartes de circuit imprimé (496) comprend en outre une troisième carte de circuit imprimé (466).

6. Capteur (450) selon la revendication 4 ou 5, dans lequel la cage (486) est connectée électriquement à un plan de masse d'au moins une de la première carte de circuit imprimé (474) et de la deuxième carte de circuit imprimé (460).

7. Capteur (450) selon l'une quelconque des revendications précédentes, dans lequel l'ensemble noyau (488) comprend en outre :
une troisième plaque (530C) agencée de manière adjacente à la deuxième plaque (530B) et connectée au premier conducteur électrique (554) ; et,
une quatrième plaque (530D) agencée de manière adjacente à la troisième plaque (530C) et connectée au deuxième conducteur électrique (556).

8. Capteur (450) selon la revendication 7, dans lequel la première plaque (530A), la deuxième plaque (530B), la troisième plaque (530C) et la quatrième plaque (530D) sont toutes agencées parallèlement les unes aux autres.

9. Capteur (450) selon la revendication 7 ou 8, comprenant en outre :
un troisième conducteur électrique (550) connecté électriquement à la deuxième plaque (530B) et à la quatrième plaque (530D), le troisième conducteur électrique (550) et la quatrième plaque (530D) sont chargés avec une tension négative et agencés de manière opérationnelle pour collecter des ions positifs ; et
un quatrième conducteur électrique (552) connecté électriquement à la première plaque (530A) et à la troisième plaque (530C), le quatrième conducteur électrique (552) et la troisième plaque (530C) sont chargés avec une tension positive et agencés de manière opérationnelle pour collecter des ions négatifs.

10. Capteur (450) selon l'une quelconque des revendications précédentes, dans lequel le premier conducteur électrique (554) et le deuxième conducteur électrique (556) sont des tiges.

11. Capteur (450) selon l'une quelconque des revendications 1 à 9, dans lequel le premier conducteur électrique (554) et le deuxième conducteur électrique (556) sont des fils.

12. Capteur (450) selon l'une quelconque des revendications 4 à 11, dans lequel la cage (486) est fixée au boîtier (452).

13. Capteur (450) selon l'une quelconque des revendications 7 à 12, dans lequel :
le troisième conducteur électrique (550) est engagé avec la deuxième plaque (530B), la troisième plaque (530C), et la quatrième plaque (530D) ; et,
le quatrième conducteur électrique (552) est engagé avec la première plaque (530A), la deuxième plaque (530B), et la troisième plaque (530C).

14. Capteur (450) selon l'une quelconque des revendications 7 à 13, dans lequel le premier conducteur électrique (554) et/ou le deuxième conducteur électrique (556) passent à travers chacune de la première plaque (530A), la deuxième plaque (530B), la troisième plaque (530C) et la quatrième plaque (530D).

15. Capteur (450) selon l'une quelconque des revendications précédentes, dans lequel l'ensemble noyau (488) est agencé sur un premier côté axial d'une plaque de support (560) et l'ensemble de cartes de circuit imprimé (496) est agencé sur un second côté axial de la plaque de support (560), opposé au premier côté axial ;
dans lequel, dans une configuration facultative, le premier conducteur électrique (554) passe à travers la plaque de support (560) pour se connecter à la première carte de circuit imprimé (474) et le deuxième conducteur électrique (556) passe à travers la plaque de support (560) pour se connecter à la deuxième carte de circuit imprimé (460).
